# EUROPÄISCHE PATENTSCHRIFT

(11) **EP 0 841 843 B1**
(45) Veröffentlichungstag und Bekanntmachung des Hinweises auf die Patenterteilung: **09.05.2001**
(21) Anmeldenummer: 97119118.4
(22) Anmeldetag: 03.11.1997
(51) Int. Cl.: H05K 7/20

(54) **Leistungsmodul zur Ansteuerung von Elektromotoren**
Power module for electrical motor drive
Module de puissance pour la commande de moteurs électriques

(30) Priorität: 06.11.1996 DE 19645636
(43) Veröffentlichungstag der Anmeldung: 13.05.1998
(73) Patentinhaber: TEMIC TELEFUNKEN microelectronic GmbH, 90411 Nürnberg (DE)
(72) Erfinder: Bäumel, Hermann, 92318 Neumarkt (DE); Geiger, Kurt, 90480 Nürnberg (DE); Kilian, Hermann, 91456 Diespeck (DE); Leicht, Günter, 96047 Bamberg (DE); Schuch, Bernhard, 91616 Neusitz (DE)
(74) Vertreter: Maute, Hans-Jürgen, Dipl.-Ing.

(56) Entgegenhaltungen:
- DE-A- 2 710 432
- US-A- 4 758 926
- US-A- 5 504 378
- US-A- 5 631 821
- J.A.ANDREWS: "Parallel printed circuit manifold" MOTOROLA TECHNICAL DEVELOPMENTS , Bd. 7, Oktober 1987, SCHAUMBURG, ILLINOIS, USA, Seiten 22-23, XP002052797

## Beschreibung

Leistungsmodule zur Ansteuerung von Elektromotoren werden vielfältig eingesetzt, beispielsweise zur Drehzahl- und Leistungsregelung der Elektromotoren (siehe zum Beispiel Patentschrift US-A-5 504 378). Sie bestehen üblicherweise aus einer Leistungseinheit, die eine Schaltungsanordnung mit Halbleiterbauelementen, insbesondere integrierte Schaltkreise (ICs) als Leistungsschalter, ein eigenes Gehäuseteil und Anschlüsse für die Spannungsversorgung, für Ausgänge (Ausgangsspannung) und für Eingänge (Ansteuerung) aufweist, aus einem separaten Kühlkörper, auf dem die Leistungseinheit zur Wärmeabfuhr, insbesondere der Leistungsschalter aufgebracht ist, und aus einer separaten Ansteuereinheit zur Ansteuerung der Leistungseinheit. Die Auswertung der Ausgangsspannung des Leistungsmoduls erfolgt in der Regel mittels einer ebenfalls separaten Verarbeitungseinheit.

Bei der Herstellung des Leistungsmoduls wird zunächst die Leistungseinheit als Standard-Baugruppe gefertigt, indem die Halbleiterbauelemente der Schaltungsanordnung auf ein Substrat aufgebracht werden, das Substrat auf eine Trägerplatte gelötet wird und das Gehäuseteil und die Anschlüsse angebracht werden. Diese Leistungseinheit als Standard-Baugruppe wird mittels ihrer Trägerplatte auf den separaten Kühlkörper aufgebracht (in der Regel über eine Zwischenschicht, beispielsweise mittels einer Wärmeleitpaste) und mit diesem verschraubt; die getrennt von der Leistungseinheit auf einem geeigneten Substrat (beispielsweise einer Leiterplatte) aufgebrachte Schaltungsordnung der Ansteuereinheit wird an die Leistungseinheit angeschlossen (in der Regel mit dieser verschraubt). Aufgrund der aufbaubedingten massiven Zuleitungen zwischen Leistungseinheit und der Spannungsversorgung sowie zwischen Leistungseinheit und Ansteuereinheit ist aus EMV-Gründen eine zusätzliche Kompensationseinheit mit einer Vielzahl von Halbleiterbauelementen (Spulen, Kondensatoren) erforderlich. Oftmals muß auch der Kühlkörper noch mit einer weiteren Kühleinheit (Flüssigkeitskühlung) zum Abführen der Verlustleistung verbunden werden.

Ein derartiger Aufbau des Leistungsmoduls bedingt folgende Nachteile:
- Der Wärmewiderstand ist durch den internen Aufbau der Leistungseinheit (Substrat, Trägerplatte), die Zwischenschicht zwischen Leistungseinheit und Kühlkörper und den separat montierten Kühlkörper bedingt, so daß ein schlechter Wärmeübergang, insbesondere zwischen den Halbleiterbauelementen (Leistungsschaltern) der Leistungseinheit und dem Kühlkörper gegeben ist.
- Durch den getrennten Aufbau der einzelnen seperat gefertigten Bestandteile bzw. funktionalen Einheiten des Leistungsmoduls und durch die erforderlichen Leitungsverbindungen zwischen den funktionalen Einheiten ist ein großer Flächen-Nolumen- und Gewichtsbedarf gegeben, womit auch hohe Kosten verbunden sind.
- Es ist ein hoher Schaltungsaufwand Vielzahl von Halbleiterbauelementen, Flächenbedarf, Kosten) für die Kompensationseinheit erforderlich.
- Die Verbindung zwischen dem Kühlkörper und der weiteren Kühleinheit ist aufwendig und oftmals nur mit schlechtem Wärmekontakt realisierbar.

Der Erfindung liegt die Aufgabe zugrunde, ein Leistungsmodul zur Ansteuerung von Elektromotoren anzugeben, bei dem diese Nachteile vermieden werden.

Diese Aufgabe wird erfindungsgemäß durch die Merkmale im Kennzeichen des Patentanspruchs 1 gelöst.

Vorteilhafte Weiterbildungen ergeben sich aus den Unteransprüchen.

Die einzelnen funktionalen Einheiten werden beim vorgestellten Leistungsmodul kompakt zusammengefaßt angeordnet, vorzugsweise in einem gemeinsamen Gehäusekörper integriert, indem
- die Halbleiterbauelemente der Schaltungsanordnung der Leistungseinheit auf ein geeignetes Substrat aufgebracht werden und dieses Substrat direkt auf einen Kühlkörper mit optimierter Oberfläche aus einem gut wärmeleitfähigen Material aufgebracht und mit diesem durch Löten (beispielsweise mittels Weichlot) verbunden wird.
- der Kühlkörper als Einfügeteil ausgebildet wird und direkt in die (Gesamt-) Kühleinheit des Leistungsmoduls integriert werden kann.
- die Ansteuereinheit in einer separaten Ebene parallel und beabstandet zum Substrat mit der Schaltungsanordnung der Leistungseinheit auf einen Trägerkörper aufgebracht wird, wobei die Halbleiterbauelemente der Ansteuereinheit einseitig oder beidseitig auf dem Trägerkörper angeordnet werden können und mit der Schaltungsanordnung der Leistungseinheit durch senkrecht angeordnete Kontaktstifte (Verbindungsbahnen oder Stege) kontaktiert werden; optional kann bei einem einseitigen Anbringen der Halbleiterbaulemente der Ansteuereinheit auf die Oberseite des Trägerkörpers auf der dem Substrat zugewandten Unterseite des Trägerkörpers eine metallische Platte als zusätzlicher Träger zwecks EMV-Abschirmung und Erhöhung der mechanischen Belastbarkeit (beispielsweise für den Einsatz in Kraftfahrzeugen) vorgesehen werden.
- in einer weiteren Ebene parallel und beabstandet zum Trägerkörper (oberhalb des Trägerkörpers) der Ansteuereinheit oder auf der Ebene der Ansteuereinheit optional weitere funktionale Einheiten zur Realisierung zusätzlicher Funktionen (beispielsweise Strommessung, Signalverarbeitung) vorgesehen werden.

Das Leistungsmodul vereinigt mehrere Vorteile in sich:
- einen kompakten Aufbau mit geringem Flächen-/Volumenbedarf und geringen Kosten.
- eine Verbesserung des Wärmeübergangs zwischen den Halbleiterbauelementen der Leistungseinheit und dem Kühlkörper durch direkte Kühlung der Halbleiterbauelemente und Integration des Kühlkörpers in die Kühleinheit.
- eine Erhöhung der Zuverlässigkeit und der Lebensdauer der Halbleiterbauelemente der Leistungseinheit und damit des Leistungsmoduls.
- aufgrund von symmetrischen und minimalen Leitungslängen der Verbindungsleitungen ist für die Kompensationseinheit nur ein minimaler Schaltungsaufwand zur Korrektur der Streuinduktivitäten erforderlich.

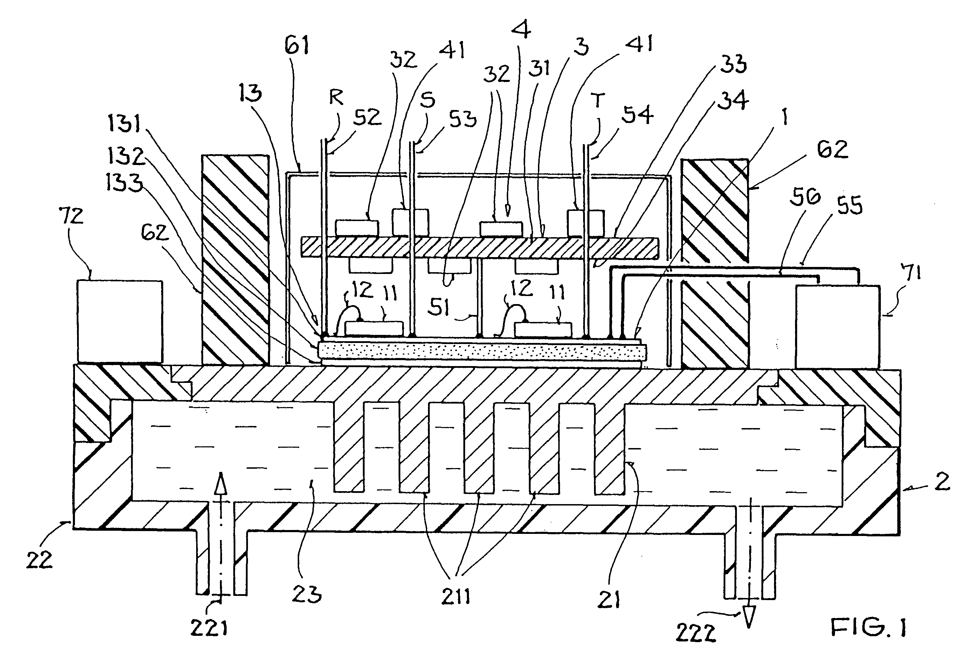

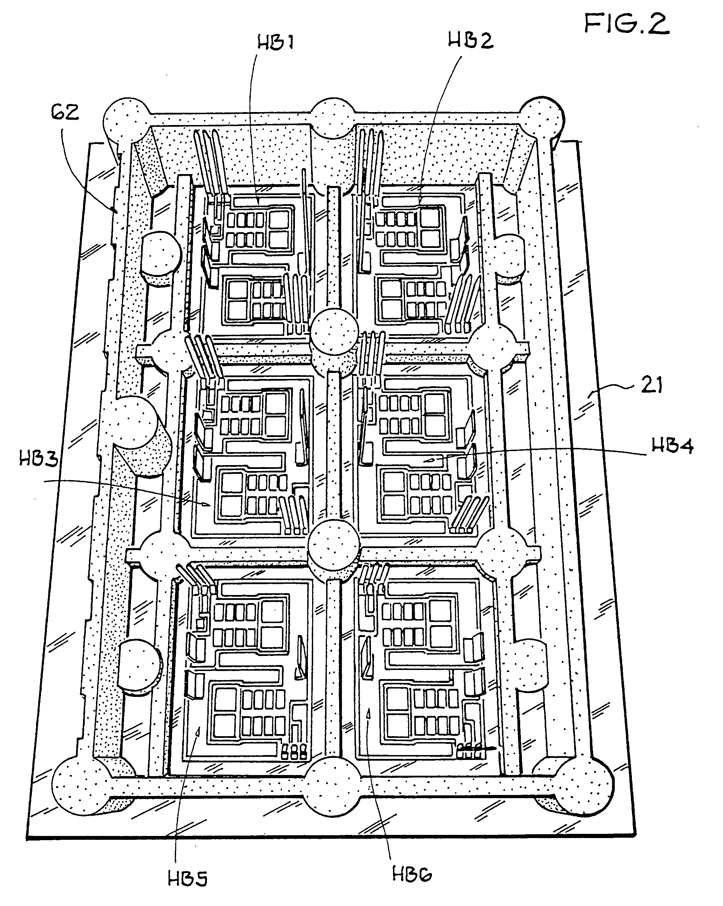

Das vorgestellte Leistungsmodul wird im folgenden anhand der Zeichnung mit den Figuren 1 und 2 für ein Ausführungsbeispiel, eines Umrichters zur Ansteuerung drehstromgetriebener Elektromotoren, beschrieben.

Hierbei zeigt die Figur 1 ein Schnittbild und die Figur 2 eine Draufsicht des Leistungsmoduls.

Gemäß den Figuren 1 und 2 werden die Halbleiterbauelemente der Schaltungsanordnung der Leistungseinheit 1 jeweils für eine Halbbrücke HB (Zweigpaar) getrennt auf einem DCB-Substrat 13 ("direct copper bonding": Keramikträger 132 zwischen zwei Kupferschichten 131, 133) mittels Lötung aufgebracht und mittels Bonddrähten 12 kontaktiert; beispielsweise sind als Halbleiterbauelemente einer Halbbrücke HB jeweils zwei IGBT-Transistoren 11 als Leistungsschalter zur Ansteuerung des Elektromotors und vier Dioden vorgesehen. Die Umrichterfunktion wird (wie aus Fig. 2 ersichtlich) mittels Parallelschaltung der Halbbrücken HB1, HB2 bzw. HB3, HB4 bzw. HB5, HB6 realisiert (für jede Phase je zwei Halbbrücken); hierdurch ist ein induktionsarmer und symmetrischer Aufbau der Zweigpaare gegeben, wobei die erforderliche Stromtragfähigkeit des Leistungsmoduls durch die Parallelschaltung zweier (ggf. auch mehrerer) DCB-Substrate 13 erreicht wird.

Die DCB-Substrate 13 werden direkt auf einen als Einfügeteil ausgebildeten Kühlkörper 21 (bsp. aus Kupfer) aufgebracht, der in die Kühleinheit 2 eingefügt wird und das Oberteil der Kühleinheit 2 darstellt; die Oberfläche des KupferKühlkörpers wird durch Rippen 211 vergrößert. Der untere Teil der Kühleinheit 2 wird durch eine Halbschale 22 (beispielsweise aus Aluminium) gebildet, in die das Kühlmedium 23 (bsp. Wasser) durch die Einlaßöffnung 221 einströmt und durch die Auslaßöffnung 222 ausströmt. Die Montagefläche der Halbleiterbauelemente der Leistungseinheit 1 ist damit in direktem Kontakt zum Kühlmedium 23 der Kühleinheit 2, so daß die Halbleiterbauelemente der Leistungseinheit 1 direkt über die Kupfer-Montagefläche 133 des DCB-Substrats 13 gekühlt werden. Hierdurch entsteht ein guter Wärmeübergang und eine gute Kühlung der Halbleiterbauelemente, insbesondere der Leistungsschalter (IGBT-Transistoren 11) der Leistungseinheit 1.

Oberhalb des DCB-Substrats 13 der Leistungseinheit 1 ist in minimalem senkrechten Abstand die auf einem Trägerkörper 31 angeordnete Ansteuereinheit 3 vorgesehen; die Halbleiterbauelemente 32 der Ansteuereinheit 3 zur Ansteuerung der Leistungseinheit 1 werden beispielsweise beidseitig auf einer Leiterplatte als Trägerkörper 31 angeordnet. (Bei einer einseitigen Anordnung der Halbleiterbauelemente 32 auf der Oberseite 33 des Trägerkörpers 31 kann auf der Unterseite 34 des Trägerkörpers 31 eine metallische Platte vorgesehen werden, die eine gute Abschirmung zur Leistungseinheit 1 und eine gute mechanische Fixierung bewirkt).

Die Kontaktierung der Ansteuereinheit 3 erfolgt mittels als Verbindungsschienen ausgebildeten Kontaktstiften 51, die bsp. auf das DCB-Substrat 13 der Leistungseinheit 1 aufgelötet werden. Die direkte Verbindung zwischen der Leistungseinheit 1 und der Ansteuereinheit 3 minimiert die Streuinduktivitäten und die Anzahl der Halbleiterbauelemente einer Kompensationseinheit; durch die senkrechte Anordnung der Kontaktstifte 51 ist eine parallele und symmetrische Kontaktierung mit vorteilhaften elektrischen Eigenschaften realisierbar.

Zur Spannungsversorgung der Halbleiterbauelemente 11, 32 von Leistungseinheit 1 und Ansteuereinheit 3 sind zwei vollflächige Stromschienen 55, 56 mit isolierender Zwischenschicht und vertauschbarer Polarität (+/-) vorgesehen, die an einen Zwischenkreis-Kondensator 71 (Kompensationsbauelement) angeschlossen sind; die Kontaktierung der Anschlüsse der Halbleiterbauelemente 11, 32 mit diesen Stromschienen 55, 56 erfolgt bsp. mittels Lötung.

Auf dem Trägerkörper 31 der Ansteuereinheit 3 sind zusätzliche Halbleiterbauelemente zur Realisierung weiterer funktionaler Einheiten 4 angeordnet; beispielsweise die Realisierung einer Strommessung über Stromwandler-Elemente 41 einschließlich einer Signalverarbeitung des Ausgangssignals der Leistungseinheit 1. Weiterhin kann eine seperate Auswerteeinheit 72 zur weiteren Signalverarbeitung vorgesehen werden.

Die (symmetrische) Zusammenführung der in verschiedenen Ebenen angeordneten funktionalen Einheiten Leistungseinheit 1, Ansteuereinheit 3 und weitere funktionale Einheiten 4 erfolgt mittels senkrechter Anschlußschienen 52, 53, 54, die die Ausgänge R, S, T des Leistungsmoduls bilden.

Die Leistungseinheit 1, die Ansteuereinheit 3 und die weiteren funktionalen Einheiten 4 des Leistungsmoduls werden in ein gemeinsames Gehäuse 61 integriert, aus dem die Anschlußschienen 52, 53, 54 als Ausgänge R, S, T und die Stromschienen 55, 56 herausgeführt werden. zusätzlich kann ein Gehäuserahmen 62 vorgesehen werden (bsp. ein Kunststoff-Gehäuserahmen), der zur Halterung der Stromschienen 55, 56 und als Begrenzung für eine Passivierung der funktionalen Einheiten Leistungseinheit 1, Ansteuereinheit 3 und weitere funktionale Einheiten 4 (beispielsweise mittels Silicon-Gel) dient.

## Patentansprüche

1. Leistungsmodul zur Ansteuerung von Elektromotoren, bestehend aus:
- einer Leistungseinheit (1) mit einer auf der Oberseite (132) eines Substrats (13) angeordneten, Leistungs-Halbleiterbauelemente (11) aufweisenden Schaltungsanordnung,
- einer von einem Kühlmedium (23) durchströmten Kühleinheit (2), die einen als Einfügeteil ausgebildeten Kühlkörper (21) mit strukturierter Oberfläche aufweist, auf den die Unterseite (133) des Substrats (13) direkt aufgebracht ist,
gekennzeichnet durch
- eine Ansteuereinheit (3) mit auf einem Trägerkörper (31) angeordneten Halbleiterbauelementen (32), der parallel und beabstandet zum Substrat (13) der Leistungseinheit (1) angeordnet ist,
- Kontaktstifte (51) zwischen dem Substrat (13) der Leistungseinheit (1) und dem Trägerkörper (31) der Ansteuereinheit (3) zur Verbindung und Kontaktierung der Schaltungsanordnung der Leistungseinheit (1) mit den Halbleiterbauelementen (32) der Ansteuereinheit (3),
- einen Gehäusekörper (61), der die Leistungseinheit (1) und die Ansteuereinheit (3) umschließt,
- zwei parallel zum Substrat (13) der Leistungseinheit (1) und zum Trägerkörper (31) der Ansteuereinheit (3) nach außen durch den Gehäusekörper (61) hindurchgeführte Stromschienen (55, 56) zur Versorgung der Schaltungsanordnung der Leistungseinheit (1),
- senkrecht zum Substrat (13) der Leistungseinheit (1) und zum Trägerkörper (31) der Ansteuereinheit (3) aus dem Gehäusekörper (61) herausgeführte, mit der Schaltungsanordnung der Leistungseinheit (1) und/oder den Halbleiterbauelementen (32) der Ansteuereinheit (3) verbundene Anschlußschienen (52, 53, 54) zum Anlegen von Steuersignalen zur Ansteuerung des Leistungsmoduls und/oder zum Abgreifen von Ausgangssignalen (R,S,T) des Leistungsmoduls.

2. Leistungsmodul nach Anspruch 1, dadurch gekennzeichnet, daß im Gehäusekörper (61) weitere funktionale Einheiten (4) angeordnet sind.

3. Leistungsmodul nach Anspruch 2, dadurch gekennzeichnet, daß als weitere funktionale Einheiten (4) eine Strommeßeinheit und/oder eine Auswerteeinheit vorgesehen sind.

4. Leistungsmodul nach einem der Ansprüche 2 oder 3, dadurch gekennzeichnet, daß die weiteren funktionalen Einheiten (4) auf mindestens einem weiteren Trägerkörper angeordnet sind, der (die) parallel und beabstandet zum Trägerkörper (31) der Ansteuereinheit (3) angeordnet ist (sind).

5. Leistungsmodul nach einem der Ansprüche 2 oder 3, dadurch gekennzeichnet, daß die weiteren funktionalen Einheiten (4) auf dem Trägerkörper (31) der Ansteuereinheit (3) angeordnet sind.

6. Leistungsmodul nach einem der Ansprüche 1 bis 5, dadurch gekennzeichnet, daß auf beiden Oberflächenseiten (33, 34) des Trägerkörpers (31) Halbleiterbauelemente (32, 41) angeordnet sind.

7. Leistungsmodul nach einem der Ansprüche 1 bis 5, dadurch gekennzeichnet, daß nur auf der dem Substrat (13) der Leistungseinheit (1) abgewandten Oberflächenseite (33) des Trägerkörpers (31) Halbleiterbauelemente angeordnet sind.

8. Leistungsmodul nach Anspruch 7, dadurch gekennzeichnet, daß auf der dem Substrat (13) der Leistungseinheit (1) zugewandten Oberflächenseite (34) des Trägerkörpers (31) eine metallische Platte angeordnet ist.

## Claims

1. A power module for controlling electric motors consisting of:
- a power unit (1) including a circuit arrangement which is disposed on the upper surface (132) of a substrate (13) and comprises a power semiconductor component (11),
- a cooling unit (2) through which there flows a cooling medium (23) and which is mounted directly on the lower surface (133) of the substrate (13) and comprises a heat sink (21) in the form of an insert member having a structured surface,
characterised by
- a control unit (3) which includes semiconductor components (32) disposed on a support body (31) and which is arranged in parallel with but spaced from the substrate (13) of the power unit (1),
- contact pins (51) between the substrate (13) of the power unit (1) and the support body (31) of the control unit (3) for connecting and contacting the circuit arrangement of the power unit (1) to the semiconductor components (32) of the control unit (3),
- a housing body (61) which surrounds the power unit (1) and the control unit (3),
- two current rails (55, 56) which are used for feeding the circuit arrangement of the power unit (1) and which are fed outwardly through the housing body (61) in parallel with the substrate (13) of the power unit (1) and the support body (31) of the control unit (3),
- terminal rails (52, 53, 54) which are used for applying control signals for controlling the power module and/or deriving output signals (R, S, T) from the power module and which are fed out of the housing body (61) perpendicular to the substrate (13) of the power unit (1) and the support body (31) of the control unit (3), and are connected to the circuit arrangement of the power unit (1) and/or to the semiconductor components (32) of the control unit (3).

2. A power module in accordance with Claim 1, characterised in that further functional units (4) are disposed in the housing body (61).

3. A power module in accordance with Claim 2, characterised in that the further functional units (4) are in the form of a current measuring unit and/or an evaluating unit.

4. A power module in accordance with either of Claims 2 or 3, characterised in that the further functional units (4) are arranged on at least one further support body which is (are) arranged in parallel with but spaced from the support body (31) of the control unit (3).

5. A power module in accordance with either of Claims 2 or 3, characterised in that the further functional units (4) are arranged on the support body (31) of the control unit (3).

6. A power module in accordance with any of the Claims 1 to 5, characterised in that semiconductor components (32, 41) are arranged on the two outer surfaces (33, 34) of the support body (31).

7. A power module in accordance with any of the Claims 1 to 5, characterised in that semiconductor components are arranged only on the outer surface (33) of the support body (31) remote from the substrate (13) of the power unit (1).

8. A power module in accordance with Claim 7, characterised in that a metal plate is arranged on the outer surface (34) of the support body (31) facing the substrate (13) of the power unit (1).

## Revendications

1. Module de puissance pour la commande de moteurs électriques, constitué par :
- une unité de puissance (1) comportant un montage disposé sur la face supérieure (132) d'un substrat (13) et comportant des composants à semiconducteurs de puissance (11),
- une unité de refroidissement (2), qui est traversée par un fluide de refroidissement (23) et possède un corps de refroidissement (21) agencé sous la forme d'un élément d'insertion et possédant une surface structurée et contre lequel est appliquée directement la face inférieure (133) du substrat (13),
caractérisé par
- une unité de commande (3) possédant des composants à semiconducteurs (32), qui sont placés sur un corps de support (31) et sont disposés parallèlement au substrat (13) de l'unité de puissance (1) et à distance de ce substrat,
- des broches de contact (51) entre le substrat (13) de l'unité de puissance (1) et le corps de support (31) de l'unité de commande (3) pour établir une liaison et un contact entre le montage de l'unité de puissance (1) et les composants à semiconducteurs (32) de l'unité de commande (3),
- un corps de boîtier (61), qui entoure l'unité de puissance (1) et l'unité de commande (3),
- deux rails de courant (55,56) qui s'étendent parallèlement au substrat (13) de l'unité de puissance (1) et au corps de support (31) de l'unité de commande (3) en traversant le corps de boîtier (61) en direction de l'extérieur, pour alimenter le montage de l'unité de puissance (1),
- des rails de raccordement (52,53,54), qui ressortent du corps de boîtier (61) perpendiculairement au substrat (13) de l'unité de puissance (1) et au corps de support (31) de l'unité de commande (30) et reliés au montage de l'unité de puissance (1) et/ou aux composants à semiconducteurs (32) de l'unité de commande (30) et servant à appliquer des signaux de commande pour la commande du module de puissance et/ou pour le prélèvement de signaux de sortie (R,S,T) du module de puissance.

2. Module de puissance selon la revendication 1, caractérisé en ce que d'autres unités fonctionnelles (4) sont disposées dans le corps de boîtier (61).

3. Module de puissance selon la revendication 2, caractérisé en ce qu'une unité de mesure du courant et/ou une unité d'exploitation sont prévues comme autres unités fonctionnelles (4).

4. Module de puissance selon l'une des revendications 2 ou 3, caractérisé en ce que les autres unités fonctionnelles (4) sont disposées sur au moins un autre corps de support, qui est disposé parallèlement au corps de support (31) de l'unité de commande (3) et à distance de ce corps.

5. Module de puissance selon l'une des revendications 2 ou 3, caractérisé en ce que les autres unités fonctionnelles (4) sont disposées sur le corps de support (31) de l'unité de commande (3).

6. Module de puissance selon l'une des revendications 1 à 5, caractérisé en ce que des composants à semiconducteurs (32,41) sont disposés sur les deux faces (33,34) du corps de support (31).

7. Module de puissance selon l'une des revendications 1 à 5, caractérisé en ce que des composants à semiconducteurs sont disposés uniquement sur la face (33) du corps de support (31), tournée à l'opposé du support (13) de l'unité de puissance (1).

8. Module de puissance selon la revendication 7, caractérisé en ce qu'une pince métallique est disposée sur la face (34) du corps de support (31), tournée vers le substrat (13) de l'unité de puissance (1).
